(19) Europäisches Patentamt
European Patent Office
Office européen des brevets

(11) EP 0 706 717 B1

## (12) EUROPEAN PATENT SPECIFICATION

(45) Date of publication and mention
of the grant of the patent:
**29.12.1999 Bulletin 1999/52**

(21) Application number: **94921306.0**

(22) Date of filing: **15.06.1994**

(51) Int Cl.⁶: **H01L 35/02**, H01L 35/20, H01L 35/32

(86) International application number:
**PCT/US94/06777**

(87) International publication number:
**WO 95/01656 (12.01.1995 Gazette 1995/03)**

(54) **COAXIAL THERMOELEMENTS AND THERMOCOUPLES MADE FROM THE COAXIAL THERMOELEMENTS**

KOAXIALE THERMOELEMENTE UND AUS DIESEN KOAXIALEN THERMOELEMENTEN HERGESTELLTE THERMOELEMENTE

THERMOELEMENTS ET THERMOCOUPLES COAXIAUX REALISES A PARTIR DE THERMOELEMENTS COAXIAUX

(84) Designated Contracting States:
**BE DE FR GB IT**

(30) Priority: **01.07.1993 US 86151**
**03.06.1994 US 254675**

(43) Date of publication of application:
**17.04.1996 Bulletin 1996/16**

(73) Proprietor: **HOSKINS MANUFACTURING COMPANY**
**Detroit, MI 48226 (US)**

(72) Inventor: **HALL, Bertie, Forrest, Jr.**
**Ann Arbor, MI 48103 (US)**

(74) Representative: **W.P. Thompson & Co.**
**Coopers Building,**
**Church Street**
**Liverpool L1 3AB (GB)**

(56) References cited:
| | |
|---|---|
| GB-A- 854 570 | GB-A- 1 594 266 |
| US-A- 764 176 | US-A- 885 430 |
| US-A- 1 651 750 | US-A- 2 466 175 |
| US-A- 2 509 825 | US-A- 2 644 851 |
| US-A- 2 987 565 | US-A- 3 013 097 |
| US-A- 3 022 361 | US-A- 3 065 286 |
| US-A- 3 116 168 | US-A- 3 283 397 |
| US-A- 3 305 405 | US-A- 3 343 589 |
| US-A- 3 449 174 | US-A- 3 463 674 |
| US-A- 3 556 864 | US-A- 3 741 816 |
| US-A- 3 774 297 | US-A- 3 819 420 |
| US-A- 3 845 706 | US-A- 3 929 511 |
| US-A- 3 973 997 | US-A- 3 980 504 |
| US-A- 4 450 314 | US-A- 4 732 619 |
| US-A- 5 111 002 | |

## Description

## Technical Field

The invention is related to the field of thermocouples and, in particular, to coaxial thermoelements and thermocouples made from the coaxial thermoelements.

## Background Art

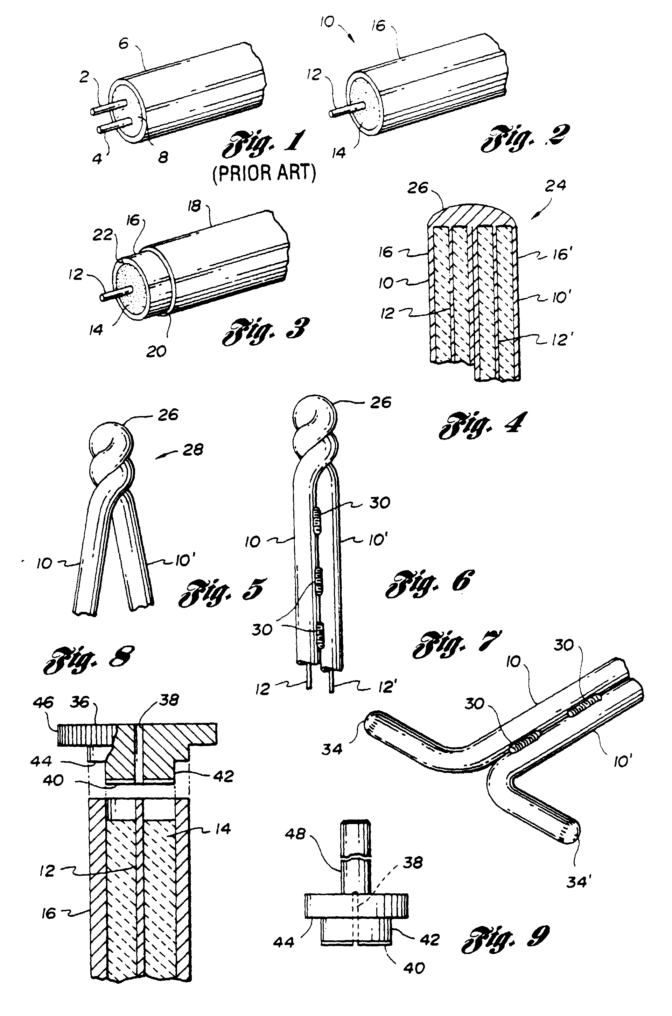

The fabrication of thermocouples using tubular metal sheaths is known in the art. Solomon in U.S. Patent No. 3,973,997, Wagner in U.S. Patent No. 3,980,504 and Nanigian in U.S. Patent No. 4,732,619 teach a thermocouple formed between a tubular metal sheathing and an internal thermocouple wire. The tubular metal sheathing and the internal wire are electrically joined at one end to form a thermocouple junction where the metal sheathing is one of the thermocouple elements and the internal wire is the other. Alternatively, as taught by Gill in U.S. Patent No. 4,512,827, two thermocouples wires, such as thermal couple wires 2 and 4 are encased in a common metal sheath, as shown in Figure 1. The thermocouple wires 2 and 4 are insulated from each other and from the metal sheath by a powdered insulating material 8.

In this type of thermocouple, the powdered insulating material solidifies during the drawing process to reduce the diameter of the thermocouple assembly, thereby making it difficult to remove the material from between the thermocouple wires and the inner walls of the metal sheathing in order to form a thermocouple junction. In addition, the thermocouple wires must be selected from thermocouple alloys to compensate for changes in their calibration that occur during manufacture. The procedure for doing this is one of trial and error. It is only after processing that the thermo-electromotive force (EMF) of the resultant thermocouple assembly is determined to be suitable for standard or special limits of error. There is little that can be done after the sheathed thermocouple cable is completed.

In the alternative, Kleinle in U.S. Patent No. 3,449,174 teaches a coaxial thermoelement in which the metal sheathing is made from the same metal or alloy as the coaxial thermocouple wire, while Black et al in U.S. Patent No. 3,463,674 discloses a thermocouple in which a thermocouple junction is formed by two thermocouple wires joined end-to-end. The thermocouple junction and the thermocouple wires are covered by an insulating layer and enclosed by a common metal sheath. A second metal sheath is added in the vicinity of the thermocouple junction and the second metal sheath is reduced by drawing or swaging to a diameter substantially equal to the diameter of the first metal sheath.

GB-A- 1594266 discloses a heat sensitive cable comprising a single conductor disposed in an insulating material and surrounded by a sheath. The single conductor extends beyond the length of the sheath.

## SUMMARY OF THE INVENTION

The invention as claimed is a coaxial thermoelement for making thermocouples and has a thermocouple wire coaxially enclosed in a tubular metal sheath and electrically insulated therefrom by a ceramic insulating material. The thermocouple wire has thermoelectric constants different from the thermoelectric constants of the tubular metal sheath. A thermocouple may be formed by electrically joining the ends of first and second coaxial thermoelements by fusing the thermocouple wire and the metal sheath of the first and second coaxial thermoelements together in a common weld bead.

According to the present invention there is provided a thermocouple comprising:

a first coaxial thermoelement having a first thermocouple wire axially disposed in a first metal sheath, and an insulator material supporting said first thermoelectric wire coaxially within said first metal sheath and insulating said first wire from said first metal sheath along the entire length of said first metal sheath, said first thermocouple wire being selected from a group of thermoelectric metals and alloys consisting of "CHROMEL", "ALUMEL", iron, copper, "CONSTANTAN", platinum and alloys of platinum and rhodium, said first metal sheath being made from a metal having a composition different from said group of thermoelectric metals and alloys; a second coaxial thermoelement having a second thermocouple wire axially disposed in a second metal sheath, and an insulator material of the second coaxial thermoelement supporting said second thermocouple wire coaxially within said second metal sheath along the entire length of said second metal sheath, said second thermocouple wire being selected from said group of thermoelectric metals, the thermoelectric metal of said second thermocouple wire being different from said thermoelectric metal of said first thermocouple wire, said second metal sheath being made from a metal having a composition substantially the same as the composition of said metal of said first metal sheath; each sheath circumscribing its associated thermocouple wire from one end to its other end to protect said wire during manufacturing and in use; means for electrically connecting to each other at one end thereof, said first metal sheath and said first thermocouple wire of said first thermoelement with said second thermocouple wire and said second metal sheath of said second coaxial thermoelement, the thermoelectric constants of the first and second thermocouple wires being different from each other, from the thermoelectric constant of the first sheath and from the thermoelectric constant of the second sheath.

Preferably the thermocouple is made by continuously inserting said first and second thermocouple wires and said insulating ceramic powder into said first and second metal sheaths as said first and second metal sheaths are being formed.

Also according to the present invention there is provided a coaxial thermoelement consisting essentially of:

a single continuous thermocouple wire having a predetermined length, said thermocouple wire being selected from a group of thermoelectric metals consisting of "ALUMEL", "CHROMEL", iron, copper, "CONSTANTAN", platinum and alloys of platinum and rhodium;

at least one tubular metal sheath circumscribing said thermocouple wire, each of said at least one tubular metal sheath extending from one end to its other end for a distance substantially equal to said predetermined length to protect the thermocouple wire during manufacturing and in use, said at least one metal sheath being made from a metal different from said thermocouple wire; and

an insulating ceramic powder disposed in said at least one metal sheath to support said thermocouple wire coaxially within said at least one metal sheath and to electrically insulate said thermocouple wire from said at least one metal sheath along said predetermined length.

One advantage of the invention is that the coaxial thermoelements can be drawn continuously without an anneal to a much greater accumulated diameter reduction than thermoelements having two thermocouple wires as taught by the prior art.

Another advantage is that the coaxial thermoelements may be calibrated individually, permitting matching of individual coaxial thermoelements to offset changes in the thermoelectric constants induced by subsequent drawing to reduce errors in the finished thermocouples.

Still another advantage is that the ends of the coaxial thermoelements may be easily cleaned to remove the ceramic insulating material from between the thermocouple wire and the metal sheathing to a depth sufficient to fuse the thermocouple wire to the metal sheath.

These and other advantages will become more apparent from a reading of the specification in conjunction with the drawings.

## Brief Description Of The Drawings

FIGURE 1 is a perspective view of a prior art thermoelement having two thermocouple wires in a common sheath;

FIGURE 2 is a perspective view of the coaxial thermoelement;

FIGURE 3 is an alternate embodiment of the coaxial thermoelement having a second sheathing layer;

FIGURE 4 is a thermocouple made from two coaxial thermoelements;

FIGURE 5 is a thermocouple in which the ends of the coaxial thermoelements are twisted about each other;

FIGURE 6 is a thermocouple in which the coaxial thermoelements are welded to each other along the length;

FIGURE 7 is a thermocouple in which the ends of the coaxial thermoelements are spatially separated;

FIGURE 8 is a cross-sectional view of an end of a coaxial thermoelement and a trepanning tool; and

FIGURE 9 is an alternate embodiment of the trepanning tool.

## Detailed Description Of The Invention

The structure of the coaxial thermoelement 10 is shown in Figure 2. The coaxial thermoelement 10 has a central thermocouple wire 12 surrounded by an insulating material 14 and enclosed within an outer metal jacket or tubular metal sheath 16. The thermocouple wire 12 may be selected from any of the metals or alloys used in the thermocouple art and may have either positive, negative, or neutral thermoelectric characteristics. For example, the thermocouple wire 12 may be made from platinum, a platinum rhodium alloy, "CHROMEL", "ALUMEL", copper, iron, constantan or any other metal or alloy used for thermocouples (CHROMEL, ALUMEL and CONSTANTAN are Trade Marks). The insulating material 14 is preferably a ceramic powder, such as magnesium oxide powder. The outer jacket or sheath 16 may be made from any metal or alloy, such as commonly used in making continuously welded tubing which has good working and drawing properties.

The coaxial thermoelement 10 is made by using standard tube forming processes such as taught by Gill in U.S. Patent No. 4,512,827. In the drawing of the coaxial thermoelement 10, only a single thermocouple wire 12 is fed into a tubular metal sheath or jacket 16 as it is being continuously formed. Gill also teaches the addition of the insulating ceramic powder into the metal sheath 16 during its fabrication process.

Although the tubular coaxial thermoelement shown in Figure 2 has only a single metal sheath 16, the metal jacket or sheath may comprise two or more metal sheaths disposed over the metal sheath 16 such as a second sheath 18 as shown in Figure 3.

In the embodiment of Figure 3, the seam 20 such as a weld or braze seam of the second metal sheath 18 is displaced from, and preferably diametrically opposite, the seam 22 of the first sheath 16. The additional layer or layers of sheathing material prevents the loss of the insulating material if a seam is accidentally or inadvertently ruptured during a subsequent drawing process or when the finished product is bent.

The advantage of the coaxial element 10 is that it may be drawn continuously without anneal to a much greater accumulated diameter reduction than the diameters currently obtainable when two thermocouple wires are enclosed in a common metal sheath as taught by the prior art.

One of the problems encountered by the prior art is that the thermoelectric constants of the thermocouple wires change when being drawn to a smaller diameter. As used herein, the thermo-electromotive force (EMF) generated by a thermocouple junction of a metal or alloy with a metal lead (Pb) is given by the equation:

$$EMF_T = A\theta^2 + B\theta$$

where $\theta$ is the temperature and A and B are constants. The metal lead is used as a standard and its thermoelectric constants A and B have been defined as being equal to 0. As a result, the thermo-electromotive force produced by thermocouples formed when both thermocouple wires are enclosed in a common sheath may change not only from batch-to-batch, but also may change within a common batch. This results in the user having to order precalibrated thermocouples having the same thermo-electromotive force characteristics as a failed thermocouple or recalibrate the system to accommodate the thermo-electromotive force characteristics of the new thermocouple.

The advantage of the coaxial thermoelements 10 is that the thermo-electromotive force characteristics of the individual coaxial thermoelements may be selected by the user to produce the desired thermo-electromotive characteristics.

A thermocouple 24 is made by joining the ends of two coaxial thermoelements 10 and 10', as shown in Figure 4. The metal sheaths 16 and 16' of the thermoelements 10 and 10' are made from the same metal and do not contribute to the electromotive force generated by the resultant thermocouple 24. The ends of the two coaxial thermoelements 10 and 10' are fused, such as by welding to form a thermocouple junction in the form of a weld bead or cap 26 connecting the metal sheaths 16 and 16' to each other as well as connecting the thermocouple wires 12 and 12' to each other.

As shown in Figure 5, the coaxial thermoelements 10 and 10' forming a thermocouple 28 may be twisted together to provide added mechanical strength at their ends adjacent to weld bead 26. Further as shown in Figure 6, the metal sheaths 12 and 12' of coaxial thermoelements 10 and 10', respectively, may be welded or otherwise electrically connected to each other along their lengths as indicated by welds 30.

Figure 7 shows an alternate embodiment of a thermocouple 32 in which the ends of the individual coaxial thermoelements 10 and 10' are separated from each other. The ends of the individual coaxial thermoelements 10 and 10' are individually sealed by welding to form weld beads 34 and 34', respectively. The metal sheaths of the coaxial thermoelement 10 and 10' are electrically connected to each other in a region adjacent to the welding beads 34 and 34', where it will be at the same temperature as the ends of the individual coaxial thermoelements 10 and 10'.

The coaxial thermoelements are user-friendly and permit the user to make his own thermocouples. As shown in Figure 8, the trepanning operation to remove the ceramic material from between the internal surface of the tubular metal sheath and the thermocouple wire member to the desired depth may be performed by a simple trepanning tool 36. The trepanning tool 36 has a through bore 38 having a diameter slightly larger than the diameter of the thermocouple wire 12 and annular cutter 40 provided at the end of an annular shaft portion 42. The depth at which the trepanning tool 36 removes the insulating material 14 from between the axially disposed thermocouple wire 12 and internal surface of the metal sheath 16 is determined by the length of the shaft portion 42. An annular shoulder 44 engages the edge of the tubular metal sheath 16 when the trepanning tool 36 has removed the insulating material 14 from between the thermocouple wire 12 and the tubular metal sheath 16 to a depth sufficient to make satisfactory weld bead 26 at the end of the coaxial thermoelement 10. The trepanning tool 36 has a knurled knob 46 which permits the trepanning tool 36 to be manually rotated.

Alternatively, the trepanning tool 36 may have a shank 48 as shown in Figure 9 by means of which it may be mounted in a suitable rotatable tool such as a power screwdriver or a drill. The ability of the ultimate user to easily remove a predetermined quantity of the insulating material from the end of the coaxial thermoelement, to permit the formation of a weld bead fusing the thermocouple wire 12 to the tubular metal sheath 16 or to another thermoelectric member having different thermoelectric constants, greatly enhances the flexibility of the coaxial thermoelectric elements.

As a result, relatively unskilled welders can repeatedly make weld beads at the end of the coaxial thermoelement 10, electrically connecting the coaxial thermocouple wire 12 with the sheath 16. The two wire, single sheath construction taught by the prior art requires a greater degree of skill and difficulties are often encountered in effectively removing the insulating material 14 from between and adjacent to the two thermocouple wires due to their non-circular configuration.

The lower cost of the coaxial thermoelements and the ease of welding leads to a higher quality thermocouple product than glass or ceramic fiber insulated thermocouple wires at a competitive price. Since the thermocouple wire 12 of the coaxial thermoelement is protected from oxidation and other types of corrosion by the tubular metal sheath 16, greater stability and longer life are assured.

Having disclosed a preferred embodiment of the invention which has been described in detail with respect to the drawings, it is recognized that hose skilled in the art may make certain changes and improvements within tne scope of the appended claims.

## Claims

1. A thermocouple comprising:

a first coaxial thermoelement having a first thermocouple wire axially disposed in a first metal sheath, and an insulator material supporting said first thermoelectric wire coaxially within said first metal sheath and insulating said first wire from said first metal sheath along the entire length of said first metal sheath, said first thermocouple wire being selected from a group of thermoelectric metals and alloys consisting of "CHROMEL", "ALUMEL", iron, copper, "CONSTANTAN", platinum and alloys of platinum and rhodium, said first metal sheath being made from a metal having a composition different from said group of thermoelectric metals and alloys;

a second coaxial thermoelement having a second thermocouple wire axially disposed in a second metal sheath, and an insulator material of the second coaxial thermoelement supporting said second thermocouple wire coaxially within said second metal sheath along the entire length of said second metal sheath, said second thermocouple wire being selected from said group of thermoelectric metals, the thermoelectric metal of said second thermocouple wire being different from said thermoelectric metal of said first thermocouple wire, said second metal sheath being made from a metal having a composition substantially the same as the composition of said metal of said first metal sheath;

each sheath circumscribing its associated thermocouple wire from one end to its other end to protect said wire during manufacturing and in use;

means for electrically connecting to each other at one end thereof, said first metal sheath and said first thermocouple wire of said first thermoelement with said second thermocouple wire and said second metal sheath of said second coaxial thermoelement,

the thermoelectric constants of the first and second thermocouple wires being different from each other, from the thermoelectric constant of the first sheath and from the thermoelectric constant of the second sheath.

2. A thermocouple as claimed in claim 1, wherein said means for electrically connecting comprises a weld bead fusing said first metal sheath and said first thermocouple wire of said first coaxial thermoelement to said second tubular metal sheath and said second thermocouple wire of said second coaxial thermoelement.

3. A thermocouple as claimed in claim 2, wherein said first and second coaxial thermoelements are twisted about each other adjacent to said one end.

4. A thermocouple as claimed in any one of the preceding claims, wherein said means for electrically connecting comprises:

a first weld bead fusing said first metal sheath and said first thermocouple wire of said first coaxial thermoelement to each other;

a second weld bead fusing said second metal sheath and said second thermocouple wire of said second coaxial thermoelement to each other; and

means for electrically connecting said first and second metal sheaths of said first and second coaxial thermoelements in a region adjacent to said first and second weld beads.

5. A thermocouple as claimed in claim 1, wherein said first and second metal sheaths of said first and second coaxial thermoelements are electrically connected to each other at predetermined locations along their length.

6. A coaxial thermoelement consisting essentially of:

a single continuous thermocouple wire having a predetermined length, said thermocouple wire being selected from a group of thermoelectric metals consisting of "ALUMEL", "CHROMEL", iron, copper, "CONSTANTAN", platinum and alloys of platinum and rhodium;

at least one tubular metal sheath circumscribing said thermocouple wire, each of said at least one tubular metal sheath extending from one end to its other end for a distance substantially equal to said predetermined length to protect the thermocouple wire during manufacturing and in use, said at least one metal sheath being made from a metal different from said thermocouple wire; and

an insulating ceramic powder disposed in said at least one metal sheath to support said thermocouple wire coaxially within said at least one metal sheath and to electrically insulate said thermocouple wire from said at least one metal sheath along said predetermined length.

7. A coaxial thermoelement as claimed in claim 6, wherein said at least one tubular metal sheath comprises a first metal sheath having a longitudinal seam, said at least one tubular metal sheath further comprising a second tubular metal sheath having a single longitudinal seam displaced from said longitudinal seam of said first tubular metal sheath.

**Patentansprüche**

1. Thermoelement, umfassend:

ein erstes koaxiales Thermoelement mit einem ersten Thermoelementdraht, der axial in einer ersten Metallhülle angeordnet ist, und einem Isolatormaterial, das den genannten ersten Thermoelementdraht koaxial in der genannten ersten Metallhülle trägt und den genannten ersten Draht von der genannten ersten Metallhülle über die gesamte Länge der genannten ersten Metallhülle isoliert, wobei der genannte erste Thermoelementdraht ausgewählt wird aus der Gruppe thermoelektrischer Metalle und Legierungen, bestehend aus "CHROMEL", "ALUMEL", Eisen, Kupfer, "CONSTANTAN", Platin sowie Legierungen aus Platin und Rhodium, wobei die genannte erste Metallhülle aus einem Metall mit einer Zusammensetzung hergestellt ist, die sich von der der geannnten Gruppe thermoelektrischer Metalle und Legierungen unterscheidet;

ein zweites koaxiales Thermoelement mit einem zweiten Thermoelementdraht, der axial in einer zweiten Metallhülle angeordnet ist, und einem Isoliermaterial des zweiten koaxialen Thermoelementes, das den genannten Thermoelementdraht koaxial in der genannten zweiten Metallhülle über die gesamte Länge der genannten zweiten Metallhülle trägt, wobei der genannte zweite Thermoelementdraht ausgewählt wird aus der genannten Gruppe thermoelektrischer Metalle, wobei sich das thermoelektrische Metall des genannten zweiten Thermoelementdrahtes von dem genannten thermoelektrischen Metall des genannten ersten Thermoelementdrahtes unterscheidet, wobei die genannte zweite Metallhülle aus einem Metall mit einer Zusammensetzung besteht, die im wesentlichen dieselbe ist wie die Zusammensetzung des genannten Metalls der genannten ersten Metallhülle;

wobei jede Hülle ihren zugehörigen Thermoelementdraht von einem Ende zum anderen umgibt, um den genannten Draht bei der Herstellung und beim Gebrauch zu schützen;

ein Mittel, um die genannte erste Metallhülle und den genannten ersten Thermoelementdraht des genannten ersten Thermoelementes elektrisch mit dem genannten zweiten Thermoelementdraht und der genannten zweiten Metallhülle des genannten zweiten koaxialen Thermoelementes jeweils an einem Ende miteinander zu verbinden;

wobei sich die thermoelektrischen Konstanten des ersten und des zweiten Thermoelementdrahtes voneinander, von der thermoelektrischen Konstante der ersten Hülle und von der thermoelektrischen Konstante der zweiten Hülle unterscheiden.

2. Thermoelement nach Anspruch 1, bei dem das genannte Mittel zum elektrischen Verbinden eine Schweißraupe umfaßt, die die genannte erste Metallhülle und den genannten ersten Thermoelementdraht des genannten ersten koaxialen Thermoelementes mit der genannten zweiten röhrenförmigen Metallhülle und dem genannten zweiten Thermoelementdraht des genannten zweiten koaxialen Thermoelementes verschmelzt.

3. Thermoelement nach Anspruch 2, bei dem das genannte erste und das genannte zweite koaxiale Thermoelement an dem genannten einen Ende umeinander gedreht sind.

4. Thermoelement nach einem der vorherigen Ansprüche, bei dem das genannte Mittel zum elektrischen Verbinden folgendes umfaßt:

eine erste Schweißraupe, die die genannte erste Metallhülle und den genannten ersten Thermoelementdraht des genannten ersten koaxialen Thermoelementes miteinander verschmelzt;

eine zweite Schweißraupe, die die genannte zweite Metallhülle und den genannten zweiten Thermoelementdraht des genannten zweiten koaxialen Thermoelementes miteinander verschmelzt; und

ein Mittel, um die genannte erste und die genannte zweite Metallhülle des genannten ersten und des genannten zweiten koaxialen Thermoelementes in einer Region neben der genannten ersten und der genannten zweiten Schweißraupe elektrisch miteinander zu verbinden.

5. Thermoelement nach Anspruch 1, bei dem die genannte erste und die genannte zweite Metallhülle des genannten ersten und des genannten zweiten koaxialen Thermoelementes an vorbestimmten Stellen über ihre Länge elektrisch miteinander verbunden sind.

6. Koaxiales Thermoelement, im wesentlichen bestehend aus:

einem einzelnen kontinuierlichen Thermoelementdraht mit einer vorbestimmten Länge, wobei der genannte Thermoelementdraht ausgewählt wird aus der Gruppe thermoelektrischer Metalle bestehend aus "ALUMEL", "CHROMEL", Eisen, Kupfer, "CONSTANTAN", Platin sowie Legierungen aus Platin und Rhodium; wenigstens einer röhrenförmigen Metallhülle, die den genannten Thermoelementdraht umgibt, wobei jede der genannten wenigstens einen röhrenförmigen Metallhülle von einem Ende zum anderen Ende über eine Entfernung verläuft, die im wesentlichen gleich der genannten vorbestimmten Länge ist, um den Thermoelementdraht bei der Herstellung und beim Gebrauch zu schützen, wobei die genannte wenigstens eine Metallhülle aus einem Metall hergestellt ist, das sich von dem des genannten Thermoelementdrahtes unterscheidet; und einem isolierenden Keramikpulver, das in der genannten wenigstens einen Metallhülle angeordnet ist, um den genannten Thermoelementdraht koaxial in der genannten wenigstens einen Metallhülle zu tragen und den genannten Thermoelementdraht elektrisch gegen die genannte wenigstens eine Metallhülle über die genannte vorbestimmte Länge zu isolieren.

7. Koaxiales Thermoelement nach Anspruch 6, bei dem die genannte wenigstens eine röhrenförmige Metallhülle eine erste Metallhülle mit einer Längsnaht umfaßt, wobei die genannte wenigstens eine röhrenförmige Metallhülle femer eine zweite röhrenförmige Metallhülle mit einer einzelnen Längsnaht umfaßt, die von der genannten Längsnaht der genannten ersten röhrenförmigen Metallhülle verschoben ist.

## Revendications

1. Un thermocouple englobant :

un premier thermoélément coaxial ayant un premier fil de thermocouple disposé axialement dans une première gaine métallique, et un matériau isolant qui supporte coaxialement ledit premier fil thermoélectrique à l'intérieur de ladite première gaine métallique et qui isole ledit premier fil de ladite première gaine métallique sur toute la longueur de ladite première gaine métallique, ledit premier fil de thermocouple étant sélectionné parmi un groupe de métaux et alliages thermoélectriques englobant « CHROMEL », « ALUMEL », fer, cuivre, « CONSTANTAN », platine et alliages de platine et de rhodium, ladite première gaine métallique étant réalisée en un métal dont la composition diffère dudit groupe de métaux et alliages thermoélectriques ;
un second thermoélément coaxial ayant un second fil de thermocouple disposé axialement dans une seconde gaine métallique, et un matériau isolant du second thermoélément coaxial supportant ledit second fil de thermocouple coaxialement à l'intérieur de ladite seconde gaine métallique sur toute la longueur de ladite seconde gaine métallique, ledit second fil de thermocouple étant sélectionné parmi ledit groupe de métaux thermoélectriques, le métal thermoélectrique dudit second fil de thermocouple étant différent dudit métal thermoélectrique dudit premier fil de thermocouple, ladite seconde gaine métallique étant réalisée en un métal ayant une composition sensiblement identique à la composition dudit métal de ladite première gaine métallique ;
chaque gaine circonscrivant son fil de thermocouple associé d'une extrémité à l'autre pour protéger ledit fil pendant sa fabrication et son utilisation ;
des moyens de connexion électrique mutuelle, à une de leurs extrémités, de ladite première gaine métallique et dudit premier fil de thermocouple dudit premier thermoélément avec ledit second fil de thermocouple et ladite seconde gaine métallique dudit second thermoélélment coaxial ;
les constantes thermoélectriques des premier et second fils de thermocouple étant différentes l'une de l'autre, différentes de la constante thermoélectrique de la première gaine et différentes de la constante thermoélectrique de la seconde gaine.

2. Un thermocouple selon la revendication 1, dans lequel lesdits moyens de connexion électrique englobent un cordon de soudure qui fusionne ladite première gaine métallique et ledit premier fil de thermocouple dudit premier thermoélément coaxial à ladite seconde gaine métallique tubulaire et audit second fil de thermocouple dudit second thermoélément coaxial.

3. Un thermocouple selon la revendication 2, dans lequel lesdits premier et second thermoéléments coaxiaux sont torsadés l'un autour de l'autre à proximité de ladite extrémité.

4. Un thermocouple selon l'une quelconque des revendications précédentes, dans lequel lesdits moyens de connexion électrique englobent :

un premier cordon de soudure qui fusionne l'une à l'autre ladite première gaine métallique et ledit premier fil de thermocouple dudit premier thermoélément coaxial;

un second cordon de soudure qui fusionne l'une à l'autre ladite seconde gaine métallique et ledit second fil de thermocouple dudit second thermoélément coaxial; et

des moyens de connexion électrique desdites première et seconde gaines métalliques desdits premier et second thermoéléments coaxiaux dans une région adjacente auxdits premier et second cordons de soudure.

5. Un thermocouple selon la revendication 1, dans lequel lesdites première et seconde gaines métalliques desdits premier et second thermoéléments coaxiaux sont connectées électriquement l'une à l'autre en des points prédéterminés sur leur longueur.

6. Un thermoélément coaxial englobant essentiellement :

un seul fil de thermocouple continu ayant une longueur prédéterminée, ledit fil de thermocouple étant sélectionné à partir d'un groupe de métaux thermoélectriques englobant « ALUMEL », « CHROMEL », fer, cuivre, « CONSTANTAN », platine et alliages de platine et de rhodium ;

au moins une gaine métallique tubulaire qui circonscrit ledit fil de thermocouple, chacune desdites gaines métalliques tubulaires (au moins une) s'étendant depuis une extrémité jusqu'à son autre extrémité sur une distance sensiblement égale à ladite longueur prédéterminée pour protéger le fil de thermocouple pendant la fabrication et l'utilisation, ladite au moins une gaine métallique étant réalisée en un métal qui diffère dudit fil de thermocouple ; et

une poudre de céramique isolante disposée dans ladite au moins une gaine métallique pour supporter coaxialement ledit fil de thermocouple à l'intérieur de ladite au moins une gaine métallique et pour isoler électriquement ledit fil de thermocouple de ladite au moins une gaine métallique le long de la distance prédéterminée.

7. Un thermoélément coaxial selon la revendication 6, dans lequel ladite au moins une gaine métallique tubulaire englobe une première gaine métallique ayant une soudure longitudinale, ladite au moins une gaine métallique tubulaire englobant de plus une seconde gaine métallique tubulaire ayant une seule soudure longitudinale déportée par rapport à ladite soudure longitudinale de ladite première gaine métallique tubulaire.

*Fig. 1*

(PRIOR ART)

*Fig. 2*

*Fig. 3*

*Fig. 4*

*Fig. 5*

*Fig. 6*

*Fig. 7*

*Fig. 8*

*Fig. 9*